# EUROPEAN PATENT SPECIFICATION

(11) **EP 2 978 076 B1**
(45) Date of publication and mention of the grant of the patent: **02.01.2019**
(21) Application number: 14770603.0
(22) Date of filing: 13.03.2014
(51) Int. Cl.: H01R 13/03, B32B 15/01, C25D 7/00, C22C 5/04, C22C 5/06, C25D 5/10, C25D 5/12, C23C 18/16

(54) **ELECTRICAL CONNECTOR, AND SOCKET FOR ELECTRIC COMPONENT**
ELEKTRISCHER VERBINDER UND BASIS FÜR EINE ELEKTRISCHE KOMPONENTE
CONNECTEUR ÉLECTRIQUE ET DOUILLE POUR COMPOSANT ÉLECTRIQUE

(30) Priority: 21.03.2013 JP 2013057696
(43) Date of publication of application: 27.01.2016
(73) Proprietor: Enplas Corporation, Kawaguchi-shi Saitama 332-0034 (JP)
(72) Inventor: ODA, Takahiro, Kawaguchi-shi Saitama 333-0844 (JP)
(74) Representative: Grünecker Patent- und Rechtsanwälte PartG mbB
(86) International application number: PCT/JP2014/056788
(87) International publication number: WO 2014/148365

(56) References cited:
- WO-A1-92/14282
- WO-A1-2008/123260
- WO-A1-2011/112939
- WO-A1-2013/183484
- WO-A1-2014/003003
- JP-A- S6 037 605
- JP-A- S59 180 908
- JP-A- 2012 230 117
- US-A- 4 628 165
- US-A- 5 728 194
- US-A1- 2008 139 058
- US-A1- 2010 163 276
- US-B1- 6 352 634

## Description

### TECHNICAL FIELD

The present invention relates to a socket for electrical component having an electrical connector installed therein, wherein the electrical connector is connected electrically to an electrical component such as a semiconductor device (hereafter referred to as "IC package").

### BACKGROUND ART

Conventionally, in an electrical connector connected electrically to an electrical component such as an IC package, there are contact pins provided in an IC socket functioning as a socket for electrical component disposed on an external conduction test circuit. The IC package is accommodated in the IC socket. As a result, connection terminals of the IC package are connected electrically to electrodes of the conduction test circuit via the connector pins. In this state, heat is applied and a burn-in test is conducted.

There are connection terminals of the IC package formed of what is called "lead-free solder", which contains tin (Sn) as a principal ingredient and which does not contain lead (Pb). In a case in which contact pins connected electrically to such connection terminals of the IC package are formed to have a gold (Au) plating layer (containing a very minute amount of Co) as the surfacemost layer and nickel (Ni) as an underlying layer, the following problem occurs.

That is, when the burn-in test is conducted, Sn contained in the connection terminals of the IC package dissolves into Au in the contact pins and diffuses therein. As a result, an Au-Sn alloy is formed, and the connection terminals of the IC package stick to the contact pins. If the connection terminals of the IC package are torn off from the contact pins after the burn-in test is completed, breakage occurs between Au-Sn layers due to the fragility of the Au-Sn alloy. As a result, some of the Au in the contact pins is removed by the connection terminal side of the IC package.
Accordingly, almost all of the Au in the contact pins is removed as the burn-in test is repeated, and Ni in the underlying layer is exposed. Therefore, Sn contained in the connection terminals of the IC package is prevented from diffusing into the material of the contact pins. Sn that has adhered to the contact pins tends to be oxidized, forming an insulator. Therefore, as the number of times the test is repeated increases, electrical resistance values between the contact pins and the connection terminals of the IC package increase abruptly, so that it becomes impossible to make electrical contact. As a result, there is a possibility that an article package that is good will be erroneously evaluated as being faulty in the burn-in test.

Therefore, as conventional contact pins, it is well known that a palladium (Pd) plating layer is formed outside Ni as the underlying layer one over the other. In addition, outside the Pd plating layer, a silver (Ag) plating layer that is lower in diffusion speed of Sn than the Pd plating layer is formed as the surfacemost layer. In a case in which the contact pins and the connection terminals of the IC package stick to each other, breakage is caused between very thin Ag-Sn alloy layers formed in the interface, and the amount of Ag in the contact pins removed is minimized (for example, see Patent Document 1).

Patent Document 2 discloses forming, on a foundation layer formed of Ni plating, a first layer in which Sn diffuses with a predetermined rate at the application of heat, formed of Pd or an alloy of Pd with Ag, Au, Cu or Sn, wherein the weight ratio of Pd is higher than that of the other elements, and a second surface layer, in which Sn diffuses slower than in the first surface layer, formed of Ag or an alloy of Ag with Au, Cu, Pd or Sn, each with a higher weight ratio of Ag.

### REFERENCE DOCUMENT LIST

### PATENT DOCUMENT

Patent Document 1: WO 2007/034921 A
Patent Document 2: WO 2013/183484 A1

### SUMMARY OF THE INVENTION

### PROBLEMS TO BE SOLVED BY THE INVENTION

The operating temperature environment demanded for the IC package tends to be high in a case in which, for example, the IC package is used in a control unit installed in an engine compartment of an automobile. Consequently, it is necessary to make the test temperature in the burn-in test high as well (for example, at least 150 °C).

In the above-described conventional contact pins, if the test temperature in the burn-in test is made high, the decrease speeds of the Ag plating layer and the Pd plating layer in the contact pins increases for reasons such as promotion of alloy formation, so that exposure of the underlying layer is hastened. As a result, the number of times of the test that can be executed until the electrical resistance value between the contact pins and the connection terminals of the IC package rises abruptly, decreases. Accordingly, there is a possibility that the service life of the IC socket will be shortened.

In view of the above described problems, it is an object of the present invention to provide a socket for an electrical component having an electrical connector installed therein, wherein the electrical connector is capable of preventing a decrease in the number of times a test can be executed until the electrical resistance value rises abruptly, when the test temperature of the burn-in test is made high.

### MEANS FOR SOLVING THE PROBLEMS

In order to solve the problems, a socket for electrical component is provided, the socket comprising:a socket main body into which an electrical component having connection terminals containing tin is accommodated; and an electrical connector, which is provided in the socket main body and which is in contact with the connection terminals of the accommodated electrical component, wherein the electrical connector is formed by laminating a plurality of layers on a base material, the plurality of layers comprising:a first layer made of a material in which a diffusion speed of tin is lower than that of palladium, among materials into which tin dissolves and diffuses by applying heat; and a second layer made, on an opposite side of the first layer from the base material, of a material in which the diffusion speed of tin is lower than that in the first layer, wherein the second layer is made of silver or an Ag alloy that includes silver as a principal ingredient, wherein the first layer is made of a Pd-Ni alloy that includes palladium and nickel as principal ingredients, or the first layer is made of a Pd-Co alloy that includes palladium and cobalt as principal ingredients.

In the case in which the first layer is made of the Pd-Ni alloy, a weight ratio of palladium may be higher than a weight ratio of nickel, in the Pd-Ni alloy. In this case, the weight ratio of palladium may be in a range of 60 to 90 weight% and the weight ratio of nickel may be in a range of 10 to 40 weight%.

In the case in which the first layer is made of the Pd-Co alloy, a weight ratio of palladium may be higher than a weight ratio of cobalt, in the Pd-Co alloy.

Furthermore, the second layer may be made of silver or an Ag alloy that includes silver as a principal ingredient. Nickel, copper, iron, or antimony may be added to the Ag alloy.

Furthermore, the second layer may be made of silver or an Ag alloy that includes silver as a principal ingredient. Alternatively, the second layer may be formed of plating on the first layer.

Furthermore, an underlying layer formed between the base material and the first layer to contain nickel may be included, and the first layer may be formed of plating on the underlying layer.

On the other hand, a socket for electrical component according to the present invention includes a socket main body into which an electrical component having connection terminals containing tin is accommodated, and the electrical connector is provided in the socket main body and is brought into contact with the connection terminals of the accommodated electrical component.

### EFFECTS OF THE INVENTION

By employing the electrical connector, and a socket for an electrical component according to the present invention, it is possible to avoid decrease in the number of times a test can be executed until the electrical resistance value rises abruptly in the case in which the test temperature in the burn-in test is made high. Therefore, as compared with a socket for an electrical component having the conventional electrical connector installed therein, it is possible to extend the service life of the socket for electrical component.

### BRIEF DESCRIPTION OF THE DRAWINGS

FIG. 1 is a partial sectional view of a socket for electrical component (IC socket) according to an embodiment of the present invention, viewed from the front thereof.
FIG. 2 is a plan view of the IC socket.
FIG. 3 is a partial enlarged view of a contact pin installed in the IC socket.
FIG. 4 is a partial sectional view of the IC socket, viewed from the side thereof.
FIG. 5 is an explanatory view of a first operation state of a contact pin according to an embodiment of the present invention.
FIG. 6 is an explanatory view of a second operation state of the contact pin according to the embodiment of the present invention.
FIG. 7 is an explanatory view of a contacting portion of a contact pin.
FIGS. 8A to 8C are views illustrating a first contacting portion in a contact pin after a burn-in test, FIG. 8A is a side view illustrating the first contacting portion, FIG. 8B is a sectional view of a conventional contact pin, and FIG. 8C is a sectional view of a contact pin according to an embodiment of the present invention.
FIGS. 9A and 9B are graphs illustrating a change of an electrical resistance value in a portion corresponding to the first contacting portion of a contact pin in a burn-in test, FIG. 9A illustrates a change in the conventional contact pin, and FIG. 9B illustrates a change in a contact pin according to an embodiment of the present invention.

### MODE FOR CARRYING OUT THE INVENTION

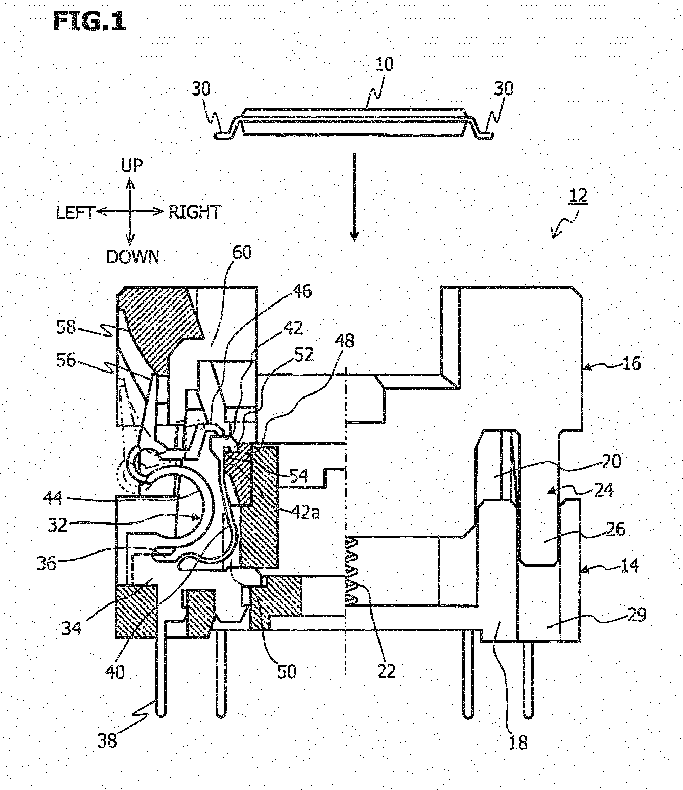

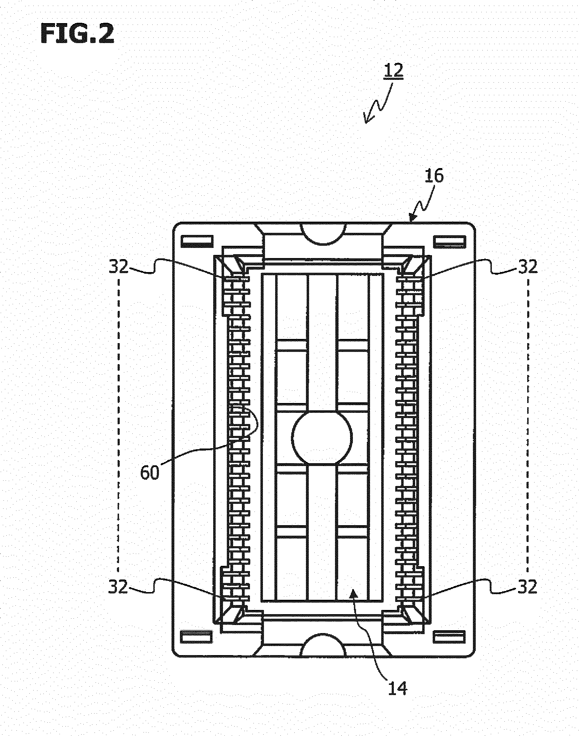

Hereunder, an embodiment of the present invention will be described with reference to the accompanying drawings. FIGS. 1 to 8C are views illustrating an embodiment of an electrical connector and a socket for electrical component according to the present invention.

In FIG. 1, an IC socket 12 functioning as a socket for an electrical component to which an IC package 10 which is an electrical component, is attached, includes a socket main body 14 and a cover 16.

The cover 16 is assembled with the socket main body 14 to be able to move up and down. More specifically, a cover guide 18 is formed on the socket main body 14. On the cover 16, a guide groove 20 engaging with the cover guide 18 so as to be capable of sliding, is formed. The cover 16 is guided by the cover guide 18 on the socket main body 14 to move up and down. The socket main body 14 and the cover 16 are made of an insulating resin material.

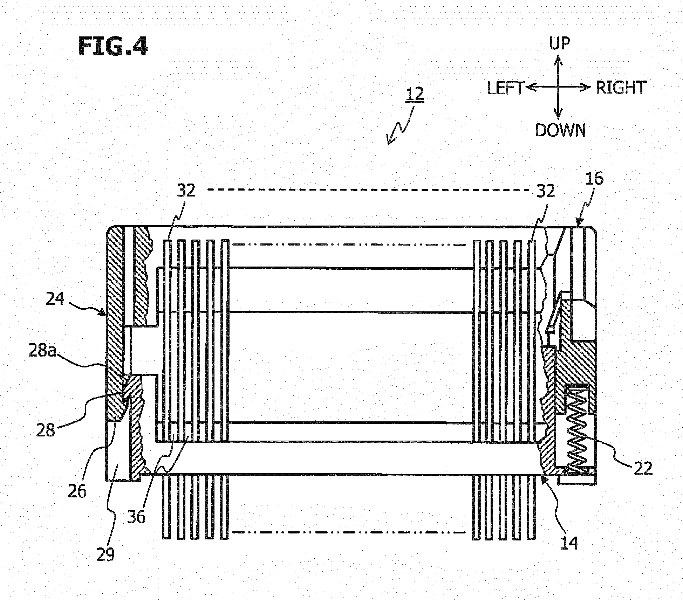

The cover 16 is assembled with the socket main body 14 to compress a coil spring 22 disposed between the socket main body 14 and the cover 16 by a predetermined amount. The cover 16 is constantly biased in an upward direction of the socket main body 14 by the coil spring 22. An upper position of the cover 16 is positioned by a stopper 24. At least one pair of the coil springs 22 is disposed in the lateral direction in FIG. 4.

The stopper 24 includes claws 26 formed on four corners of the cover 16, and claws 28 of the socket main body 14 engaging with the claws 26. The claws 26 of the cover 16 are engaged in grooves 29 formed in the socket main body 14 so as to be capable of sliding therein. If the cover 16 is pushed downward in FIG. 4, the claws 26 are elastically deformed outwardly along slanting surfaces 28a of the claws 28 of the socket main body 14 to pass over the claws 28 of the socket main body 14, so that the claws 26 are engaged with the claws 28 of the socket main body 14. As a result, the cover 16 is assembled with the socket main body 14.

A plurality of contact pins 32 are attached to the socket main body 14 as an electrical connector which connects connection terminals 30 of the IC package 10 to an external conduction test circuit (not illustrated). The connection terminals 30 are formed to include what is called "lead-free solder" which contains tin (Sn) as a principal ingredient and which does not contain lead (Pb).

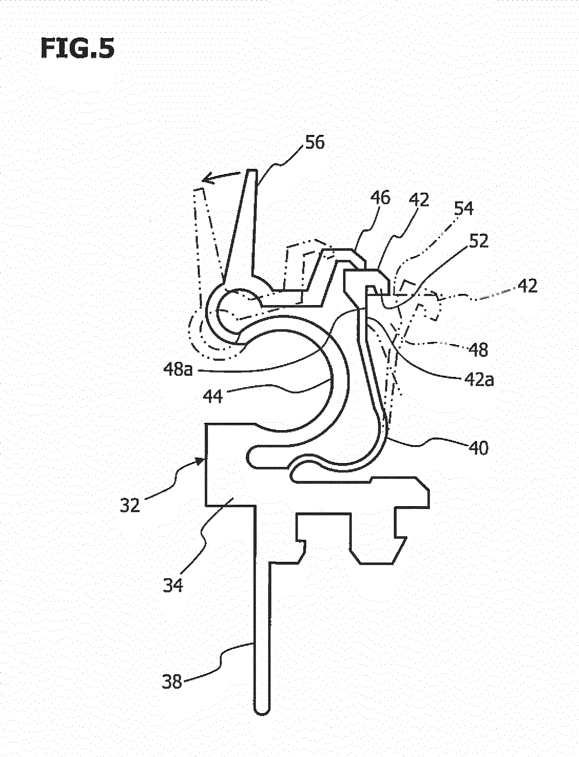

The contact pins 32 are fixed at their base portions 34 to the socket main body 14 by, for example, press fitting. The contact pins 32 are partitioned by ribs 36 formed on the socket main body 14 to avoid contact with other adjacent contact pins 32. As illustrated in FIG. 1 and FIG. 5, the contact pins 32 have connection arms 38 projecting from the base portions 34 in a downward direction of the socket main body 14. The connection arms 38 are connected to the conduction test circuit, which is not illustrated.

As shown in FIG. 1 and FIG. 5, each of the contact pins 32 has a first contacting portion 42 connected to the base portion 34 via a first spring portion 40, and a second contacting portion 46 connected to the base portion 34 via a second spring portion 44.

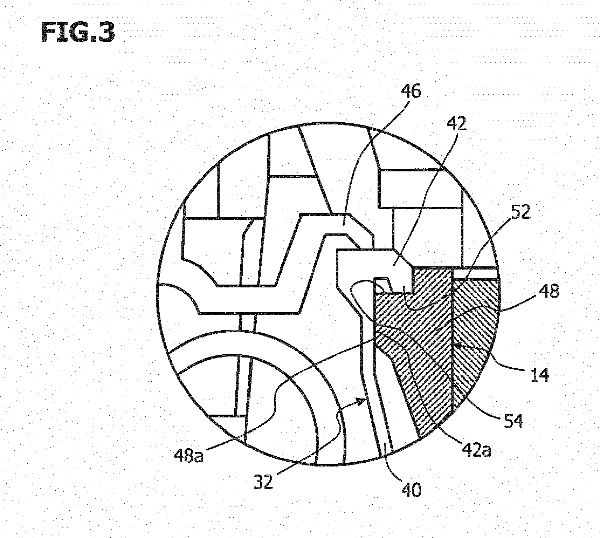

The first spring portion 40 is attached to an engaging groove 50 in a pin support block 48 of the socket main body 14 in a state in which the first spring portion 40 is deformed elastically from a position indicated by a two-dot chain line in FIG. 5 to a position indicated by a solid line. A positioning step portion 52 is formed in the first contacting portion 42. As illustrated in FIG. 3, the positioning step portion 52 is pressed against a positioning engaging portion 54 formed on the pin support block 48 of the socket main body 14 by elastic force of the first spring portion 40, and positioning of the first contacting portion 42 is conducted in a vertical direction. At this time, tensile stress is generated in the first spring portion 40. The positioning step portion 52 is pressed against the positioning engaging portion 54 by the tensile force generated in the first spring portion 40. Furthermore, a bottom end portion side surface 42a of the first contacting portion 42 is pressed against a side end surface 48a of the pin support block 48 by elastic force of the first spring portion 40, and positioning of the first contacting portion 42 is conducted in a lateral direction.

As illustrated in FIG. 1 and FIG. 5, the second spring portion 44 has, at the upper end part thereof, an arm 56 formed to project upward in FIG. 1 and FIG. 5,. If the cover 16 is pushed and lowered against spring force of the coil spring 22, the arm 56 is pressed by a pressing part slope 58 that is formed to have a cross-sectional shape of a circular arc inside the cover 16, and is moved to a positon indicated by the two-dot chain line in FIG. 1 and FIG. 5. At this stage, the second spring portion 44 is deformed to bend in a counterclockwise direction in FIG. 5. As a result, the second contacting portion 46 is retracted from an upper end surface of the first contacting portion 42, and the upper end surface of the first contacting portion 42 becomes exposed.

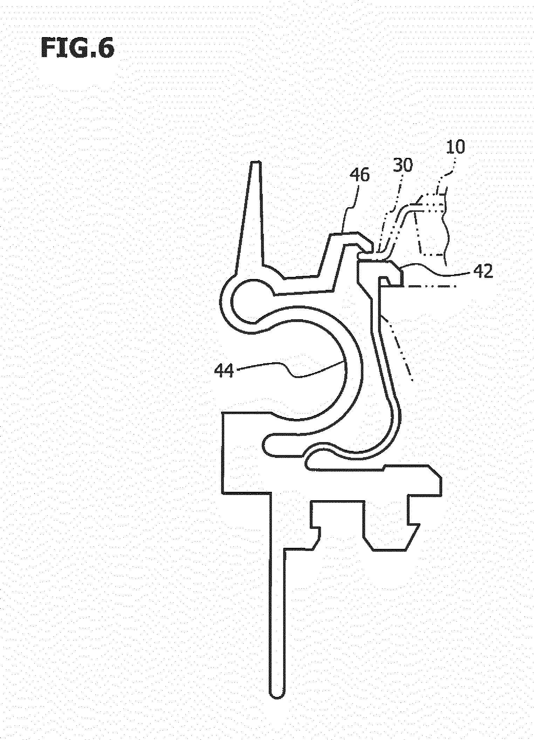

In the state in which the cover 16 is pressed and lowered against the spring force of the coil spring 22, the IC package 10 is inserted in the cover 16 through an IC package insertion opening 60 formed on the cover 16 and is accommodated in the socket main body 14. The connection terminals 30 of the IC package 10 are brought into contact with the upper end surfaces of the first contacting portions 42, respectively, in one-to-one relationship. If the pressing down force acting on the cover 16 is then removed, the cover 16 returns to the original position due to the spring force of the coil spring 22. As a result, the second spring portion 44 displaces from the two-dot chain line position in FIG. 5 in the clockwise direction. As illustrated in FIG. 6, the second contacting portion 46 presses the connection terminal 30 of the IC package 10 toward the upper surface of the first contacting portion 42 due to elastic force of the second spring portion 44. Therefore, the connection terminal 30 of the IC package 10 is sandwiched between the first contacting portion 42 and the second contacting portion 46 certainly with a predetermined contact pressure. Consequently, the conduction test circuit, which is not illustrated, electrically connects to the IC package 10 via the contact pins 32. As a result, the IC package 10 is mounted to the IC socket 12. In the mounted state, the conduction test, such as the burn-in test, is conducted on the IC package 10.

When the conduction test is finished, the cover 16 is pressed and lowered against the spring force of the coil spring 22 and the arm 56 is pressed by the pressing part slope 58 of the cover 16, and then the second spring portion 44 is subjected to bending deformation so that the second contacting portion 46 is retracted from an upper surface of the connection terminal 30 to be moved to a position indicated by the two-dot chain line position illustrated in FIG. 1 and FIG. 5. After that, the IC package 10 is taken out from an IC package insertion opening 60 to the outside of the cover 16, and a shift to a conduction test on the next IC package 10 is conducted.

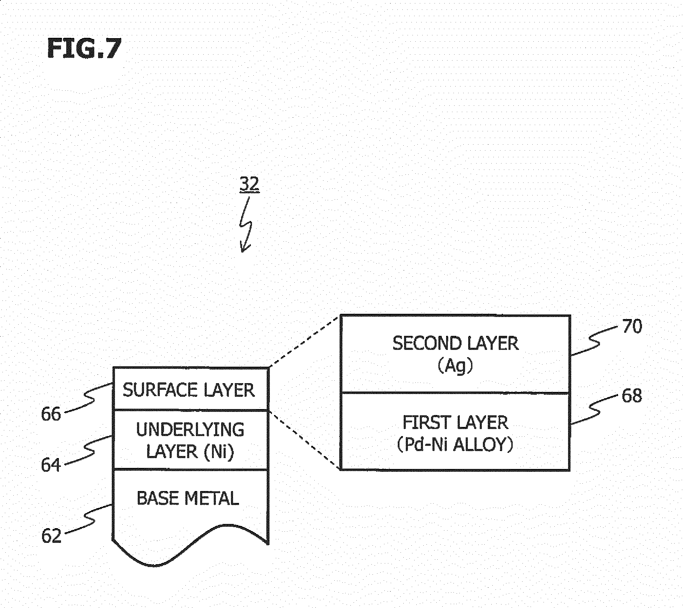

Materials of the contact pin 32 will now be described. As illustrated in FIG. 7, the contact pin 32 includes a plurality of layers obtained by laminating a base material 62, an underlying layer 64 formed on a surface side (hereafter referred to as "contact side") of the base material 62 that is brought into contact with the connection terminal 30 of the IC package 10, and a surface layer 66 formed on the contact side of the underlying layer 64. In other words, the surface layer 66 is located on the contact side of the contact pin 32.

The base material 62 is made of a conductive material. In the present embodiment, taking into consideration that elasticity is needed in the contact pin 32, for example, a beryllium copper (Be-Cu) alloy is employed. Furthermore, the underlying layer 64 is made of, for example, nickel (Ni) plating that is in the range of 2 × 10⁻⁶ to 3 × 10⁻⁶ m. The base material 62 and the underlying layer 64 are not limited to such materials, and they may be made of other suitably selected materials.

The surface layer 66 includes at least two layers. In the present embodiment, the surface layer 66 includes two layers obtained by laminating a first layer 68 formed on a contact side of the underlying layer 64, and a second layer 70 formed on a contact side of the first layer 68. At least one layer may be formed on at least one of a contact side of the second layer 70 and a base material 62 side of the first layer 68. For example, in order to suppress sticking between the contact pin 32 and the connection terminal 30 of the IC package 10 caused by the burn-in test, a layer including one of Sn, gold (Au), palladium (Pd) and zinc (Zn) may be provided on the contact side of the second layer 70 as the surfacemost layer. Furthermore, at least one layer may be formed between the first layer 68 and the second layer 70.

The first layer 68 is made of a material in which a diffusion speed of Sn is lower than that of Pd among materials into which Sn dissolves and diffuses by applying heat. In the present embodiment, the first layer 68 is made of a Pd-Ni alloy having Pd and Ni as principal ingredients. With regard to a weight ratio between Pd and Ni in the Pd-Ni alloy, Pd is higher than Ni. For example, Pd is in the range of 60 to 90 weight%, whereas Ni is in the range of 40 to 10 weight%.

The first layer 68 must have a thickness of at least 0.1 × 10⁻⁶ m to obtain the function that Sn dissolves and diffuses therein. However, the thickness may be set equal to at least 0.2 × 10⁻⁶ m to prolong the time for which Sn diffuses. On the other hand, the thickness of the first layer 68 may be set equal to 5 × 10⁻⁶ m or less to reduce occurrence of cracks.

The first layer 68 is not limited to the Pd-Ni alloy as long as the first layer 68 is made of a material in which the diffusion speed of Sn is lower than that of Pd among materials into which Sn dissolves and diffuses by applying heat. In another embodiment, the first laver 68 is made of a Pd-Co alloy including Pd and cobalt (Co). In the Pd-Co alloy as well, Pd is greater in a weight ratio between Pd and Co. For example, Pd is 90 weight%, whereas Co is 10 weight%.

The first layer 68 is formed by means of, for example, a manufacturing method using plating, or a manufacturing method using ion plating. In the manufacturing method using plating, Ni plating is applied as the underlying layer 64, Au strike plating is applied thereon as an adhesion layer, and Pd-Ni alloy plating is superimposed as the first layer 68. In the manufacturing method using ion plating, Ni plating is applied as the underlying layer 64, and the Pd-Ni alloy is adhered thereon as the first layer 68 by ion plating.

The second layer 70 is made of a material into which Sn dissolves and diffuses by applying heat, but a diffusion speed of Sn is lower than that in the first layer 68. In the present embodiment, the second layer 70 is made of silver (Ag). The second layer 70 must have a thickness of at least 0.1 × 10⁻⁶ m to delay the diffusion of Sn into the first layer 68. The diffusion speed of Sn into the first layer 68 differs depending on the atmospheric temperature around the contact pin 32. Therefore, at a temperature of at least 150°C, the thickness of the second layer 70 may be set equal to at least 0.3 × 10⁻⁶ m to delay the diffusion of Sn into the first layer 68, and at a temperature of at least 180°C, the thickness of the second layer 70 may be set equal to at least 1 × 10⁻⁶ m for the same purpose.

The second layer 70 is formed on the first layer 68 by means of, for example, a manufacturing method using plating or a manufacturing method using ion plating in the same way as the above-described manufacturing method of the first layer 68.

The second layer 70 is not limited to Ag, as long as the second layer 70 is made of a material into which Sn dissolves and diffuses by applying heat, and in which the diffusion speed of Sn is lower than that in the first layer 68. The material may be, in another embodiment, a silver alloy including Ag and any one of four elements Ni, copper (Cu), iron (Fe), and antimony (Sb) as principal ingredients. These elements are thought to inhibit alloying of Ag in the silver alloy and Sn in the connection terminal 30 of the IC package 10. Furthermore, the second layer 70 may be a silver alloy obtained by adding Sn, Au or the like in addition to the above-described four elements, to Ag.

When the contact pin 32 and the IC socket 12 are employed, it is possible to reduce the decrease in the number of times a test can be executed until the electrical resistance value between the contact pin 32 and the connection terminal 30 of the IC package 10 rises abruptly, in the case in which the test temperature of the burn-in test is made high. Therefore, as compared with an IC socket having the conventional contact pins, it is possible to extend the service life of the IC socket 12. The reason for this will now be described.

In the conventional contact pin, the first layer is a plating layer of Pd which is employed among materials into which Sn dissolves and diffuses by applying heat. In the Pd plating layer, diffusion speed of Sn is extremely high and absorption amount of Sn is extremely large which are similar to Au. Mechanical strength of a Pd-Sn alloy is extremely higher than that of an Au-Sn alloy. The second layer is further formed on a contact side of the first layer, and the second layer is a plating layer of Ag. Ag is a material, into which Sn dissolves and diffuses by applying heat, in which diffusion speed of Sn is lower than that in the first layer. Accordingly, the speed at which Sn contained in the connection terminal 30 of the IC package 10 dissolves into the contact pin side becomes slow. As a result, an Ag-Sn alloy or an Sn-Pd alloy is not formed abruptly, but is formed gradually. Consequently, the connection terminal 30 of the IC package 10 and the contact pin via the Ag-Sn alloy or the Sn-Pd alloy formed after the burn-in test are difficult to stick therebetween to suppress the decrease speed of the first layer and the second layer.

If the test temperature in which the burn-in test is conducted is made higher (for example, at least 150°C), the speed at which the Ag-Sn alloy is formed between Sn contained in the connection terminal 30 of the IC package 10 and Ag in the second layer increases. As a result, sticking between the second layer in the contact pin and the connection terminal 30 of the IC package 10 is more likely to occur. The thickness of the Ag-Sn alloy also increases, and thus, if the connection terminal 30 of the IC package 10 is peeled off from the contact pin, Ag in the second layer is more likely to decrease as compared with the case in which the test temperature is not made high. Furthermore, if the Ag plating layer in the second layer is missing, Sn contained in the connection terminal 30 of the IC package 10 and Pd in the first layer form the Sn-Pd alloy at a speed faster than alloying speed between Sn and Ag in the second layer. Consequently, the first layer in the contact pin and the connection terminal 30 of the IC package 10 are more likely to stick to each other. As compared with the case in which the test temperature is not made high, therefore, Pd in the first layer also is more likely to decrease. As compared with the case in which the test temperature is not made high, therefore, exposure of Ni, which is the underlying layer, is hastened. Sn contained in the connection terminal 30 of the IC package 10 does not diffuse into the material of the contact pin, but is accumulated on an interface of the underlying layer. Consequently, Sn that has adhered to the contact pin tends to oxidize, forming an insulator. As a result, there is a decrease in the number of times a test can be executed until the electrical resistance value between the contact pin and the connection terminal 30 of the IC package 10 rises abruptly. Consequently, there is a possibility that the service life of the IC socket will be shortened.

On the other hand, in the contact pin 32 in the present embodiment, the plating layer of the Pd-Ni alloy is formed as the first layer 68. In the Pd-Ni alloy, among materials into which Sn dissolves and diffuses by applying heat, the diffusion speed of Sn is lower than Pd.

Therefore, the alloying speed between Sn and the Pd-Ni alloy is lower than the alloying speed between Sn and Pd, and thus, even in the case in which the Ag plating layer in the second layer 70 is missing, the first layer 68 in the contact pin 32 in the present embodiment is difficult to stick to the connection terminal 30 of the IC package 10 and the first layer 68 is difficult to decrease, as compared with the conventional contact pin.

Furthermore, the plating layer of the Pd-Ni alloy is able to absorb Sn in large amounts in the same way as the plating layer of the Pd single substance. However, the plating layer of the Pd-Ni alloy is superior in mechanical strength to the plating layer of the Pd single substance, and thus, even if the IC package 10 is peeled from the contact pin 32 in the case in which the Pd-Ni alloy in the first layer 68 is alloyed with Sn in the connection terminal 30 of the IC package 10, the Pd-Ni alloy in the first layer 68 is difficult to peel off and decrease.

Therefore, as compared with the conventional contact pin, exposure of Ni, which is the underlying layer 64, is slow. The number of times a test can be executed until the occurrence of an abrupt rise in the electrical resistance value between the contact pin 32 and the connection terminal 30 of the IC package 10, increases. Accordingly, as compared with an IC socket having the conventional contact pin, it is possible to extend the service life of the IC socket 12.

An evaluation test that demonstrates the effects of the present invention will now be described. In the evaluation test, the state of alloy forming and the change of the electrical resistance value in a portion corresponding to the first contacting portion 42 illustrated in FIG. 3 etc., are compared between the conventional contact pin and the contact pin according to the present embodiment. The conventional contact pin includes the Pd plating layer in the first layer and the Ag plating layer in the second layer. The contact pin according to the present embodiment (hereafter referred to as "improved contact pin") includes the Pd-Ni alloy plating layer in the first layer and the Ag plating layer in the second layer.

### (1) Specifications of tested IC socket

Four IC sockets having the conventional contact pins attached thereto (hereafter referred to as "conventional IC sockets) and four IC sockets having the improved contact pins attached thereto (hereafter referred to as "improved IC sockets") were prepared. Configurations of the IC sockets were the same.

In both the conventional contact pins and the improved contact pins, the Be-Cu alloy was employed in the base material. Each of the conventional contact pins was formed by applying Ni plating in the range of 2 × 10⁻⁶ to 3 × 10⁻⁶ m onto the base material as an underlying layer, applying a Pd plating layer of 0.5 × 10⁻⁶ m on the underlying layer as the first layer, and applying an Ag plating layer of 2 × 10⁻⁶ m on the first layer as the second layer.

Furthermore, each of the improved contact pins was formed by applying Ni plating in the range of 2 × 10⁻⁶ to 3 × 10⁻⁶ m onto the base material as an underlying layer, applying a Pd-Ni alloy plating layer of 0.5 × 10⁻⁶ m on the underlying layer as the first layer, and applying an Ag plating layer of 1 × 10⁻⁶ m on the first layer as the second layer.

### (2) Specifications of terminals of tested IC package

An IC package in which each connection terminal was made of a Sn-3Ag-0.5Cu alloy was employed.

### (3) Test method

A test procedure follows: an unused IC package was attached to each of four conventional IC sockets and four improved IC sockets, that is, eight IC sockets in total. In this state, the ambient temperature of the IC socket was raised to 200°C, and this temperature was maintained for 24 hours, after that, the ambient temperature was lowered to room temperature, and then, the IC package was removed from the IC socket. Regarding this as one cycle, 15 cycles were executed successively.

With regard to the electrical resistance value of the contacting portion of the contact pin in contact with the connection terminal of the IC package, measurement was conducted on contact pins of each IC socket at a stage in which each of 1 cycle, 5 cycles, 10 cycles, and 15 cycles was finished.

Furthermore, regarding the state of alloy forming, a section of a portion corresponding to the first contacting portion 42 was observed by using a microscope at a stage in which 15 cycles were completed.

### (4) Results

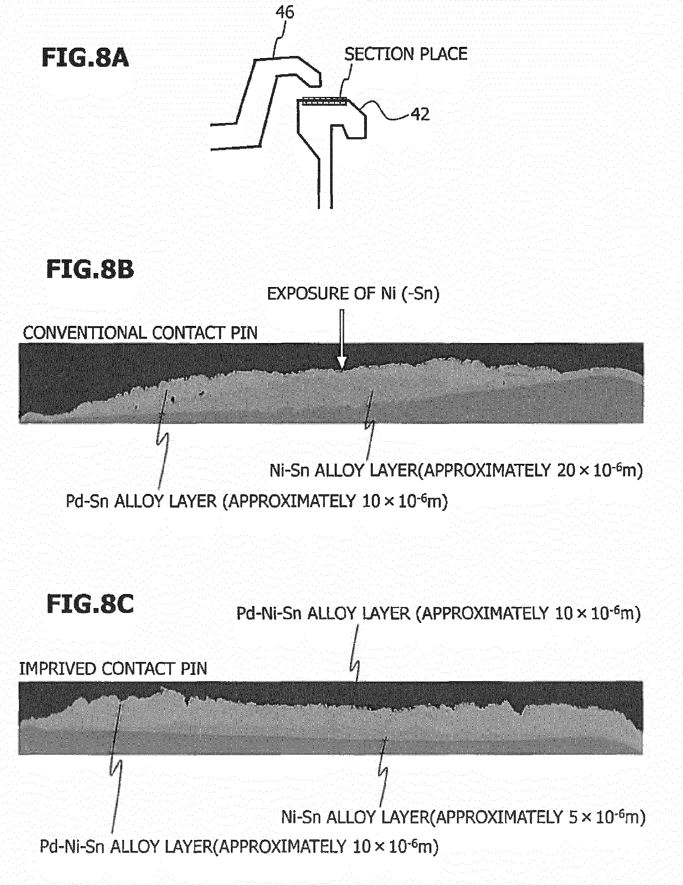

With regard to alloy forming states in the conventional contact pins after the burn-in test was finished, as illustrated in FIG. 8B, the Ag plating layer, which is the second layer, was lost, and the Pd-Sn alloy layer obtained by that Sn diffuses into the Pd plating layer, which is the first layer, to be alloyed therewith, was also almost lost locally, and Ni in the underlying layer was exposed. Such results thus were obtained. In some conventional contact pins, Ni in the underlying layer was exposed at a stage in which 10 cycles were finished in the burn-in test.

On the other hand, regarding the alloy forming state in the improved contact pins after the burn-in test was finished, as illustrated in FIG. 8C, the Ag plating layer in the second layer was lost. However, the Pd-Ni-Sn alloy layer obtained by that Sn diffuses into the Pd-Ni alloy plating layer which is the first layer to be alloyed therewith, remained in the whole region of a portion corresponding to the first contacting portion 42, and Ni in the underlying layer was not exposed. Such results were thus obtained. Furthermore, the thickness of the Ag plating layer, which is the second layer in the improved contact pins, was half of the thickness of the Ag plating layer, which is the second layer in the conventional contact pins, nevertheless, the remaining amount of the first layer was larger in the improved contact pins. This resulted in anticipation that the remaining amount of the first layer in the improved contact pins would further increase if the thickness of the Ag plating layer in the second layer was set equal to that in the conventional contact pins.

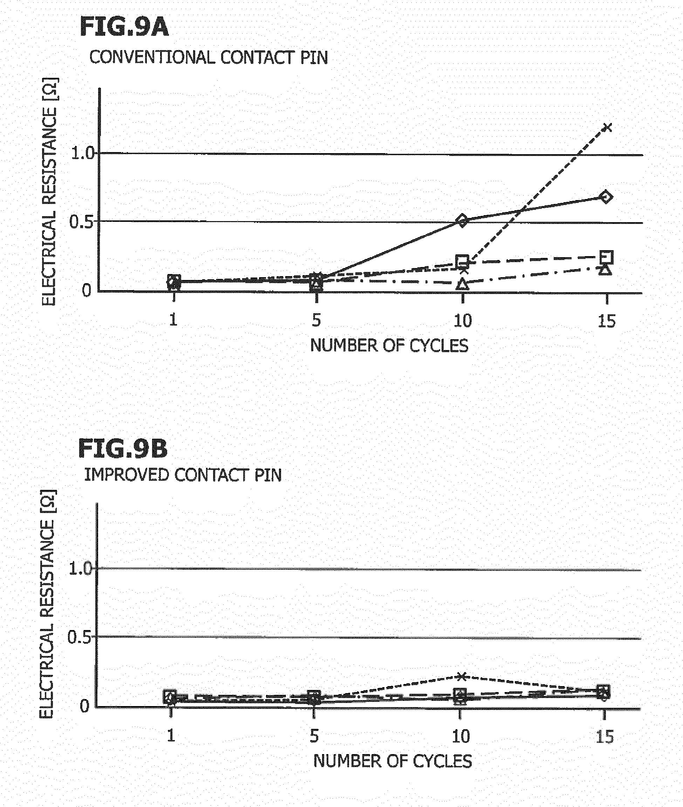

As illustrated in FIG. 9A, with regard to a change of an electrical resistance value of the conventional contact pins after a predetermined number of cycles were finished in the burn-in test, at a stage in which 10 cycles were finished, a marked rise of the electrical resistance value was observed, and at a stage in which 15 cycles were finished, the electrical resistance value tended to rise further. Such results were thus obtained.

On the other hand, as illustrated in FIG. 9B, with regard to a change of an electrical resistance value of the improved contact pins after a predetermined number of cycles were finished in the burn-in test, a marked rise of the electrical resistance value did not occur. Such a result was thus obtained.

On the basis of the abovementioned results, it is clear that, in a case in which the test temperature in the burn-in test is made high, it is possible to reduce the decrease in the number of times a test can be executed until occurrence of an abrupt rise in the electrical resistance value between the contact pin and the connection terminal of the IC package. As a result, it is clear that the service life of the IC socket 12 having the improved contact pins can be extended as compared with the IC socket having the conventional contact pins.

In the foregoing description, the IC socket 12 of open top type is used as an example of a socket for an electrical component to which the IC package 10 is attached. However, the socket for an electrical component is not limited to the IC socket 12 of the open top type. As long as the IC socket includes a socket main body, in which the IC package 10 can be accommodated, and an electrical connector that is provided in the socket main body so as to be in contact with the connection terminals 30 of the accommodated IC package 10, and that has a layer structure similar to that in the contact pin 32 according to the above-described embodiment, the IC socket may be a socket of another type such as, for example, a socket of the clamshell type.

The contact pin 32 functioning as the electrical connector is applied to the IC socket 12, however, the contact pin 32 may be applied to uses other than the IC socket.

### REFERENCE SYMBOL LIST

- 10: IC package
- 12: IC socket
- 14: Socket main body
- 30: Connection terminal
- 32: Contact pin
- 42: First contacting portion
- 46: Second contacting portion
- 62: Base material
- 64: Underlying layer
- 66: Surface layer
- 68: First layer
- 70: Second layer

## Claims

1. A socket for electrical component, the socket (12) comprising:
a socket main body (14) into which an electrical component (10) having connection terminals (30) containing tin is accommodated; and
an electrical connector (32), which is provided in the socket main body (14) and which is in contact with the connection terminals (30) of the accommodated electrical component (10), wherein
the electrical connector (32) is formed by laminating a plurality of layers on a base material (62), the plurality of layers comprising:
a first layer (68) made of a material in which a diffusion speed of tin is lower than that of palladium, among materials into which tin dissolves and diffuses by applying heat; and
a second layer (70) made, on an opposite side of the first layer (68) from the base material (62), of a material in which the diffusion speed of tin is lower than that in the first layer, wherein
the second layer (70) is made of silver or an Ag alloy that includes silver as a principal ingredient,
**characterized in that**
the first layer (68) is made of a Pd-Ni alloy that includes palladium and nickel as principal ingredients, or the first layer (68) is made of a Pd-Co alloy that includes palladium and cobalt as principal ingredients.

2. The socket according to claim 1, wherein the first layer (68) is made of a Pd-Ni alloy, wherein a weight ratio of palladium is greater than a weight ratio of nickel.

3. The socket according to claim 2, wherein the weight ratio of palladium is in a range of 60 to 90 weight% and the weight ratio of nickel is in a range of 10 to 40 weight%.

4. The socket according to claim 1, wherein the first layer (68) is made of a Pd-Co alloy, wherein a weight ratio of palladium is greater than a weight ratio of cobalt.

5. The socket according to claim 1, wherein nickel is added to the Ag alloy.

6. The socket according to claim 1, wherein copper is added to the Ag alloy.

7. The socket according to claim 1, wherein iron is added to the Ag alloy.

8. The socket according to claim 1, wherein antimony is added to the Ag alloy.

9. The socket according to claim 1, further comprising an underlying layer (64) which is formed between the base material (62) and the first layer (68) and contains nickel, wherein the first layer (68) is formed of plating on the underlying layer (64), and
the second layer (70) is formed of plating on the first layer (68).

## Patentansprüche

1. Sockel für elektrisches Bauteil, wobei der Sockel (12) umfasst:
einen Sockel-Hauptkörper (14), in dem ein elektrisches Bauteil (10) aufgenommen ist, das Verbindungsanschlüsse (30) aufweist, die Zinn enthalten; sowie
einen elektrischen Verbinder (32), der sich in dem Sockel-Hauptkörper (14) befindet und der in Kontakt mit den Verbindungsanschlüssen (30) des aufgenommenen elektrischen Bauteils (10) ist, wobei
der elektrische Verbinder (32) ausgebildet wird, indem eine Vielzahl von Schichten auf einem Trägermaterial (62) übereinander angeordnet werden, wobei die Vielzahl von Schichten umfasst:
eine erste Schicht (68), die von Materialien, in denen sich Zinn durch Anwendung von Wärme löst und diffundiert, aus einem Material besteht, in dem eine DiffusionsGeschwindigkeit von Zinn niedriger ist als die von Palladium; sowie
eine zweite Schicht (70) an einer von dem Trägermaterial (62) gegenüberliegenden Seite der ersten Schicht (68), die aus einem Material besteht, indem die DiffusionsGeschwindigkeit von Zinn niedriger ist als die in der ersten Schicht, wobei
die zweite Schicht (70) aus Silber oder einer Ag-Legierung besteht, die Silber als einen Hauptbestandteil enthält,
**dadurch gekennzeichnet, dass**
die erste Schicht (68) aus einer Pd-Ni-Legierung besteht, die Palladium und Nickel als Hauptbestandteile enthält, oder die erste Schicht (68) aus einer Pd-Co-Legierung besteht, die Palladium und Kobalt als Hauptbestandteile enthält.

2. Sockel nach Anspruch 1, wobei die erste Schicht (68) aus einer Pd-Ni-Legierung besteht und ein Gewichtsanteil von Palladium größer ist als ein Gewichtsanteil von Nickel.

3. Sockel nach Anspruch 2, wobei der Gewichtsanteil von Palladium in einem Bereich von 60 bis 90 Gew.-% legt und der Gewichtsanteil von Nickel in einem Bereich von 10 bis 40 Gew.-% liegt.

4. Sockel nach Anspruch 1, wobei die erste Schicht (68) aus einer Pd-Co-Legierung besteht und ein Gewichtsanteil von Palladium größer ist als ein Gewichtsanteil von Kobalt.

5. Sockel nach Anspruch 1, wobei der Ag-Legierung Nickel zugesetzt ist.

6. Sockel nach Anspruch 1, wobei der Ag-Legierung Kupfer zugesetzt ist.

7. Sockel nach Anspruch 1, wobei der Ag-Legierung Eisen zugesetzt ist.

8. Sockel nach Anspruch 1, wobei der Ag-Legierung Antimon zugesetzt ist.

9. Sockel nach Anspruch 1, der des Weiteren eine Grundschicht (64) umfasst, die zwischen dem Trägermaterial (62) und der ersten Schicht (68) ausgebildet ist und Nickel enthält, wobei die erste Schicht (68) durch Plattieren auf der Grundschicht (64) ausgebildet wird, und
die zweite Schicht (70) durch Plattieren auf der ersten Schicht (68) ausgebildet wird.

## Revendications

1. Douille pour composant électrique, la douille (12) comprenant:
un corps principal de douille (14) dans lequel est logé un composant électrique (10) ayant des bornes de connexion (30) contenant de l'étain; et
un connecteur électrique (32) qui est prévu dans le corps principal de la douille (14) et qui est en contact avec les bornes de connexion (30) du composant électrique logé (10), dans lequel
le connecteur électrique (32) est formé en stratifiant une pluralité de couches sur un matériau de base (62), la pluralité de couches comprenant:
une première couche (68) constituée d'un matériau dans lequel la vitesse de diffusion de l'étain est inférieure à celle du palladium, parmi les matériaux dans lesquels l'étain se dissout et diffuse en appliquant de la chaleur; et
une seconde couche (70) réalisée sur un côté opposé de la première couche (68) au matériau de base (62) en un matériau dans lequel la vitesse de diffusion de l'étain est inférieure à celle de la première couche, dans laquelle
la seconde couche (70) est constituée d'argent ou d'un alliage d'Ag qui comprend de l'argent comme ingrédient principal,
**caractérisé en ce que**
la première couche (68) est constituée d'un alliage Pd-Ni qui comprend du palladium et du nickel comme ingrédients principaux, ou la première couche (68) est constituée d'un alliage Pd-Co qui comprend du palladium et du cobalt comme ingrédients principaux.

2. Douille selon la revendication 1, dans laquelle la première couche (68) est constituée d'un alliage Pd-Ni, dans lequel un rapport pondéral du palladium est supérieur à un rapport pondéral du nickel.

3. Douille selon la revendication 2, dans laquelle le rapport pondéral du palladium est compris dans la plage de 60 à 90% en poids et le rapport pondéral du nickel est compris entre la plage de 10 à 40% en poids.

4. Douille selon la revendication 1, dans laquelle la première couche (68) est constituée d'un alliage Pd-Co, dans lequel un rapport pondéral du palladium est supérieur à un rapport pondéral du cobalt.

5. Douille selon la revendication 1, dans lequel on ajoute du nickel à l'alliage Ag.

6. Douille selon la revendication 1, dans lequel on ajoute du cuivre à l'alliage Ag.

7. Douille selon la revendication 1, dans lequel on ajoute du fer à l'alliage Ag.

8. Douille selon la revendication 1, dans lequel on ajoute de l'antimoine à l'alliage Ag.

9. Douille selon la revendication 1, comprenant en outre une couche sous-jacente (64) qui est formée entre le matériau de base (62) et la première couche (68) et contient du nickel, dans lequel la première couche (68) est formée d'un revêtement sur la couche sous-jacente (64), et
la seconde couche (70) est formée en un revêtement sur la première couche (68).
